# EUROPÄISCHE PATENTSCHRIFT

(11) **EP 1 520 838 B1**
(45) Veröffentlichungstag und Bekanntmachung des Hinweises auf die Patenterteilung: **22.02.2012**
(21) Anmeldenummer: 04022269.7
(22) Anmeldetag: 18.09.2004
(51) Int. Cl.: B81C 3/00, B01L 3/00, F16L 13/11

(54) **Verfahren und Vorrichtung zum Koppeln von Hohlfasern an ein mikrofluidisches Netzwerk**
Method and apparatus for coupling hollow fibers to a microfluidical network.
Methode et dispositv pour coupler des fibres vides à un reseau microfluidique.

(30) Priorität: 30.09.2003 DE 10345817
(43) Veröffentlichungstag der Anmeldung: 06.04.2005
(60) Teilanmeldung: 10010260.7
(73) Patentinhaber: Boehringer Ingelheim microParts GmbH, 44227 Dortmund (DE)
(72) Erfinder: Yu, Ying, Dr., 44225 Dortmund (DE); Peters, Ralf-Peter, Dr., 51467 Bergisch-Gladbach (DE); Stöters, Wolfgang, Dipl.-Ing., 45481 Mülheim (DE)
(74) Vertreter: Gesthuysen, von Rohr & Eggert

(56) Entgegenhaltungen:
- WO-A-01/86154
- WO-A-97/29394
- WO-A-98/25065
- FR-A- 2 813 073

## Beschreibung

Die Erfindung betrifft zunächst ein Verfahren zum Koppeln mindestens einer Hohlfaser an ein mikrofluidisches Netzwerk mit den Merkmalen des Oberbegriffs von Anspruch 1. Weiter betrifft die Erfindung auch eine Vorrichtung zur Realisierung eines solchen Verfahrens, nämlich ein mikrofluidisches System aus einem mikrofluidischen Netzwerk mit einem Mikrostrukturträger und einer angekoppelten mikrofluidischen Hohlfaser mit den Merkmalen des Oberbegriffs von Anspruchs 17.

In der Mikrosystemtechnik ist es bekannt, Komponenten mit mikrostrukturierten Oberflächen durch Klebung miteinander zu verbinden. Mit solchen Verfahren werden oft nur zwei planparallele Flächen miteinander verklebt. Dabei fließt ein Kleber in einer Ebene. Um die zu verbindenden Komponenten mit einer ausreichenden Positioniergenauigkeit miteinander zu verkleben, müssen sie vor dem eigentlichen Klebevorgang durch eine andere Technik relativ zueinander vorläufig fixiert werden. Das ist dann schwierig, wenn mehrere Teile auf unterschiedlichen Ebenen fluidisch dicht miteinander verklebt werden sollen, insbesondere dann, wenn eine der miteinander zu verklebenden Komponenten vergleichsweise beweglich ist, insbesondere bei einer Hohlfaser.

Für sich ist es im übrigen bekannt, einen im Verarbeitungszustand flüssigen Kleber durch Ausnutzung von Kapillarkräften in eng bemaßte Kanäle, Nuten oder andere Funktionsbereiche fließen zu lassen (vgl. insbesondere Wolfgang Menz; Jürgen Mohr: "Mikrosystemtechnik für Ingenieure", VCH Verlagsgesellschaft mbH, 2. Aufl. 1997, ISBN 3-527-29405-8).

Die DE 34 08 783 C2 betrifft ein Verbindungselement für Lichtwellenleiter, wobei die Lichtwellenleiter in mikrostrukturierte Nuten eingeklebt werden.

Aus der vom Europäischen Patentamt zu der prioritätsbegründenden deutschen Patentanmeldung 103 45 817.4 durchgeführten Standardrecherche RS 111293 sind folgende Druckschriften bekannt:

Die WO 98/25065 A1, die den Ausgangspunkt der vorliegenden Erfindung bildet, offenbart ein mikrofluidisches Netzwerk, wobei mindestens eine Hohlfaser in einen Kanal eingeklebt wird. Die Hohlfaser wird in den Kanal eingelegt, der Kanal wird durch eine Abdeckplatte abgedeckt, und anschließend wird - bedarfsweise über einen seitlichen Zulauf - ein Klebstoff zugeführt, der bedarfsweise durch UV-Strahlung insbesondere im Bereich des stimseitigen Endes der Hohlfaser aushärtbar ist und die Hohlfaser im Kanal verklebt. Das bekannte Verfahren stellt jedoch eine optimale Positionierung der Hohlfaser im Kanal nicht sicher. Problematisch ist insbesondere, daß überschießender Klebstoff unerwünschterweise in das eingeführte, offene Ende der Hohlfaser eindringen und diese verschließen kann.

Die WO 97/29394 A 1 betrifft das Einkleben einer optischen Faser in eine V-Nut, wobei Klebstoff über zwei gegenüberliegende, seitliche Zulaufkanäle der V-Nut zugeführt wird, so daß eine vollständige Ummantelung der Faser mit Klebstoff vermieden werden kann.

Die WO 01/86154 A1 offenbart das Einkleben eines Kapillarrohrs in einen Kanal, wobei die Innenfläche des Kanals und die Außenfläche des Kapillarrohrs in vorbestimmter Orientierung und Abstand zueinander gehalten werden, um einen gewünschten Kapillareffekt dazwischen zu erreichen, und wobei Klebstoff in einer abgestimmten Menge zugeführt wird, um den Zwischenraum zu füllen. Die Bestimmung und Einhaltung dieser Menge ist jedoch schwierig und ggf. aufwendig. Problematisch ist insbesondere, daß überschießender Klebstoff unerwünschterweise in das eingeführte, offene Ende der Hohlfaser eindringen und diese verschließen kann.

Die FR 2 813 073 A 1 offenbart das Einkleben von Kapillaren in V-förmigen Nuten einer Mikrostruktur, wobei mehrere Kapillare mittels eines Halteelements in die gegenüber einer Abdeckung vorspringenden Nuten eingeführt und bis unter die Abdeckung geschoben werden und anschließend mittels Klebstoff in den Nuten verklebt werden. Problematisch ist insbesondere, daß überschießender Klebstoff unerwünschterweise in das eingeführte, offene Ende der Hohlfaser eindringen und diese verschließen kann.

Der vorliegenden Erfindung liegt die Aufgabe zugrunde, ein Verfahren zum Koppeln mindestens einer mikrofluidischen Hohlfaser an ein mikrofluidisches Netzwerk und ein damit versehenes mikrofluidisches System anzugeben, wobei ein unerwünschtes Verschließen der Hohlfaser durch Klebstoff an ihrem eingeführten, offenen Ende auf einfache Weise sicher vermieden werden kann und insbesondere eine gewünschte Positionierung und Festlegung der Hohlfaser und/oder ein optimales gleichzeitiges Verkleben und Abdichten mehrerer Teile ermöglicht werden.

Die obige Aufgabe wird durch ein Verfahren gemäß Anspruch 1 oder ein mikrofluidisches System gemäß Anspruch 17 gelöst. Vorteilhafte Weiterbildungen sind Gegenstand der Unteransprüche.

Erfindungsgemäß wird durch eine im Bereich des Endes der Hohlfaser bzw. an deren offener Mündung im Kanal gebildete Kapillarstopstruktur erreicht, daß der Kleber beim Einfüllen vor oder am Ende der Hohlfaser stehen bleibt und dementsprechend die Hohlfaser nicht verschließen kann. Die Kapillarstopstruktur ist sehr einfach und kostengünstig herstellbar und gestattet ein sehr einfaches Einfüllen des Klebers, da insbesondere keine zusätzlichen Vorkehrungen zur Verhinderung eines Verschließens der Hohlfaser durch den Kleber getroffen werden müssen. Vielmehr genügt bei der bevorzugten Ausgestaltung die Kapillarstopstruktur, um den Klebstoffstrom zum stirnseitigen Ende der Hohlfaser hin zu stoppen. Die erfindungsgemäße Lösung gestattet dementsprechend eine sehr einfache Herstellung der erfindungsgemäßen mikrofluidischen Systeme, da beispielsweise keine besonders abgestimmte Menge an Kleber zugeführt werden muß und da es beispielsweise auch nicht erforderlich ist, den Klebstoff aktiv durch lokales Aushärten o. dgl. vor dem Ende der Hohlfaser zu stoppen.

Eine vorgesehene, zumindest vorläufige Fixierung der im Kanal eingeführten Hohlfaser durch die Abdeckfolie oder -platte, insbesondere bis zum Einfüllen und Aushärten des Klebers, ermöglicht auf sehr einfache Weise eine sehr genaue Positionierung und Festlegung der Hohlfaser. Dies ist einem definierten Verbinden und Abdichten zuträglich. Des weiteren wird eine einfache und schnelle Herstellung gestattet, da insbesondere keine zusätzlichen Haltemittel o. dgl. zur Positionierung der Hohlfaser im Kanal während des Verklebens erforderlich sind.

Insbesondere wird der Vorteil erreicht, daß eine für das Kleben konstruierte einfache Kanalstruktur, die sich auf dem mikrofluidischen Mikrostrukturträger befindet, gleichzeitig zwei Funktionen erfüllt. Zum einen wird eine an sich bewegliche Hohlfaser vor dem Kleben durch die Struktur so fixiert, daß die Hohlfaser exakt in ihrer Sollposition liegt und sich praktisch nicht mehr bewegt. Zum anderen wird der im Verarbeitungszustand flüssige Kleber durch die Kanalstruktur des Mikrostrukturträgers optimal in den zu klebenden Bereich geführt. Mikrofluidische Baugruppen können somit mit beweglichen Komponenten fluidisch dicht und ohne Verstopfung geklebt werden. Das muß nicht nur in einer Ebene geschehen, sondern kann sich auch über mehrere Koppelpunkte in mehreren Ebenen erstrecken im Sinne eines dreidimensionalen mikrofluidischen Netzwerks.

Mit der Erfindung wird erreicht, daß man mikrofluidische Hohlfasern an ein mikrofluidisches Netzwerk mit mikrostrukturierten Kanälen auf einem von einer Abdeckfolie oder Abdeckplatte abgedeckten Chip durch Kleben verbinden kann, ohne zusätzliche dichtende Komponenten zu benötigen. Eine Abdeckplatte in diesem Sinne kann auch ein weiterer mikrostrukturierter Chip sein.

Nach weiterer Lehre der Erfindung gewährleisten Kapillarstopstrukturen und/oder Ablaufkanäle eine genaue Dosierung des Klebers im Verarbeitungszustand, so daß die Hohlfaser oder Hohlfasern im Kanal oder den Kanälen flüssigkeitsdicht geklebt sind, wobei aber der Kanal im Inneren der Hohlfaser von jedem Klebstoffeintritt frei bleibt.

Besonders bevorzugt ist dieses System aufgrund der Tatsache, daß das Verfahren in der Produktion eingesetzt werden kann, da die unvermeidlichen Schwankungen im Dosierungssystem des Klebers durch die Kanalstruktur im Mikrostrukturträger von selbst kompensiert werden.

In verfahrenstechnischer Hinsicht gilt zunächst, daß der im Verarbeitungszustand flüssige Kleber die zwischen Hohlfaser und Kanalwandungen verbleibenden Kapillarkanäle unter Nutzung der Kapillarkräfte, die dort auftreten, ausfüllt. Danach wird der Kleber in den Endzustand gebracht, insbesondere ausgehärtet. Auch durch Temperaturerhöhung kann eine Aushärtung erfolgen. Es hängt vom Material des Klebers ab, wie der Endzustand erreicht wird.

Für eine optimale Funktionsweise des erfindungsgemäßen Verfahrens ist es besonders zweckmäßig, wenn die Kapillarität der Kapillarkanäle größer ist als die Kapillarität des Zulaufkanals und/oder des Ablaufkanals. Dadurch ist sichergestellt, daß der flüssige Kleber in der gewünschten Weise zwischen Hohlfaser und Kanalwandungen eintritt. Hinsichtlich der quantitativen Bemessung der Kapillaritäten kommt es auf die Kanalquerschnitte, die Viskosität des Klebers, die Benetzungsfähigkeit des Klebers auf der spezifischen Oberfläche etc. an. Das wird im einzelnen vom Fachmann für den jeweiligen Anwendungsfall ermittelt.

Überdies muß festgestellt werden, daß die Kanäle, in denen die Hohlfasern einliegen, am anderen Ende zur Umgebungsatmosphäre offen sind, um ein Einlaufen des Klebers in die Kapillarkanäle zu ermöglichen. Das ist jedenfalls bevorzugt, wenn man nicht mit gezielten Druckerhöhungen oder gezieltem Unterdruck arbeiten will.

Interessant ist, daß man mit dem erfindungsgemäßen System mittels eines Ablaufkanals überschüssigen Kleber im Verarbeitungszustand aus dem Kanal ableiten kann.

Zusätzlich zur Kapillarstopstruktur kann auch eine Maske mit einem Schlitz an der richtigen Stelle, an der der Kleber im Kapillarkanal stehen bleiben soll, vorgesehen werden. Beispielsweise durchtritt hier UV-Strahlung eine Abdeckfolie, die ansonsten für UV-Strahlung nicht durchlässig ist. Der Kleber, der die Durchlaßstelle erreicht, härtet hier aus und kann demzufolge nicht weiter fließen.

Alternativ oder zusätzlich wird das Fließen des Klebers in den Kapillarkanälen beobachtet und ggf. gezielt das Aushärten des Klebers eingeleitet.

Man kann für die Hohlfaser Polymermaterial einsetzen, es sind aber auch Metallkapillaren, Glaskapillaren sowie Kapillaren aus Keramik oder Cellulose bekannt, die die Funktion einer solchen Hohlfaser erfüllen können. Hohlfasern dieser Art sind auch und insbesondere Dialysefasern wie sie in Dialysegeräten eingesetzt werden.

Besondere Viskositätsbereiche für den flüssigen Klebstoff, der den Kleber im Verarbeitungszustand bildet, sind Gegenstand des Anspruchs 9. Insbesondere handelt es sich um unter UV-Strahlung aushärtende Kleber gemäß Anspruch 10.

Ein für UV-Strahlung empfindlicher Kleber erfordert eine entsprechende Abdeckfolie oder Abdeckplatte, das ist in Anspruch 11 geschildert.

In verfahrenstechnischer Hinsicht von besonderer Bedeutung ist Anspruch 12, durch den klargestellt wird, daß nach bevorzugter Lehre der Erfindung der Kleber drucklos, d. h. nur unter der Wirkung des Eigendruckes des Klebervorrats in den Kanal eingeleitet wird. Insbesondere die Kapillarkräfte in den Kapillarkanälen sind also für das "Einziehen" des Klebers verantwortlich. Das stellt sicher, daß die Kapillarstopstrukturen im Mikrostrukturträger ihre Wirkung sicher entfalten, so daß der im Inneren der Hohlfaser gebildete Längskanal nicht blockiert wird.

Von besonderer Bedeutung ist eine verfahrentechnische Maßnahme des Anspruchs 13, wobei das Aushärten bevorzugt nach dem verfahrenstechnischen Rezept von Anspruch 14 erfolgt.

Grundsätzlich ist es möglich, in einem Kanal eine Hohlfaser anzuordnen. Nach Anspruch 15 ist es aber auch zweckmäßig, in einem Kanal mehr als eine Hohlfaser, insbesondere zwei Hohlfasern anzuordnen, die gleichzeitig mit dem Kleber verklebt werden. Grundsätzlich ist es auch möglich, zwei Hohlfasern, die ineinander geschoben sind, mit einer solchen Kapillarklebetechnik zu verbinden.

Im Normalfall wird man in einem Mikrostrukturträger des mikrofluidischen Netzwerks eine Vielzahl von Kanälen haben, die eine Vielzahl von Hohlfasern endseitig aufnehmen. Dafür bietet nun Anspruch 16 eine besonders bevorzugte verfahrenstechnische Lösung, die eine Kopplung der Kanäle erlaubt. Das kann man gruppenweise vorsehen, was eine bevorzugte Lösung sein wird.

Hinsichtlich des bereits oben angesprochenen mikrofluidischen Systems wird nun anschließend mit Bezug auf die Zeichnung eine Erläuterung bevorzugter Ausführungsbeispiele angeschlossen. In der Zeichnung zeigt
- Fig. 1: in einer perspektivischen, dreidimensional anmutenden Darstellung das Grundprinzip eines erfindungsgemäßen mikrofluidischen Systems,
- Fig. 2: das mikrofluidische System aus Fig. 1 in einer Draufsicht.

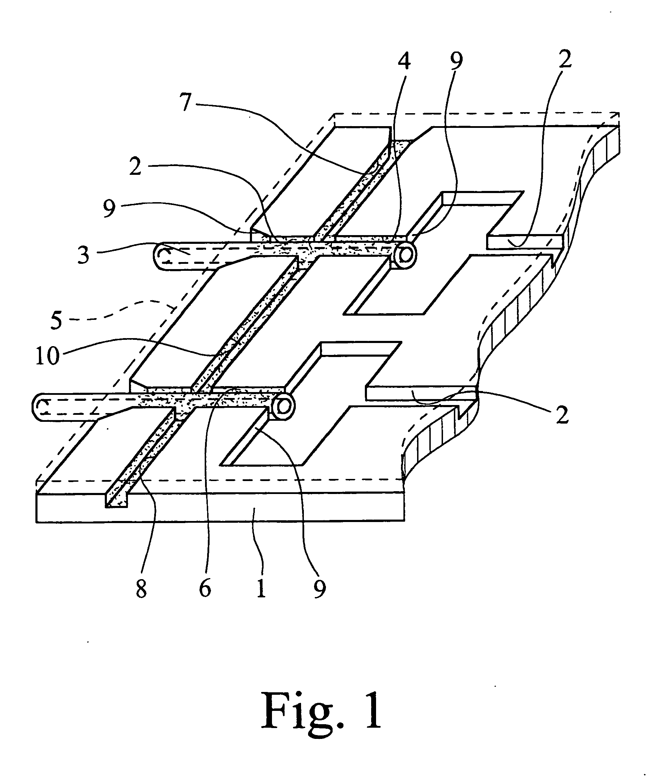

Das in Fig. 1 dargestellte mikrofluidische System aus einem mikrofluidischen Netzwerk mit einem Mikrostrukturträger 1 mit mindestens einem Kanal 2 und einer mit einem Ende im Kanal 2 eingelegten, stirnseitig in den Kanal 2 mündenden mikrofluidischen Hohlfaser 3, ist dadurch gekennzeichnet, daß die Außenabmessungen, insbesondere der Außendurchmesser, der Hohlfaser 3 so auf die Innenabmessungen, insbesondere die Breite und die Tiefe, des Kanals 2 abgestimmt sind, daß sich zwischen der Hohlfaser 3 und den Wandungen des Kanals 2, insbesondere in in den Winkeln verbleibenden Zwickeln, Kapillarkanäle 4 ergeben, daß das Netzwerk mit einer auf dem Mikrostrukturträger 1 fixierten Abdeckfolie oder -platte 5 abgedeckt ist, die den Kanal 2 schließt, und daß die Kapillarkanäle 4 von einem fluidisch dichtenden Kleber 6 ausgefüllt sind. Fig. 1 läßt nur gestrichelt angedeutet und maßlich nicht maßstabgerecht die Abdeckfolie 5 erkennen, bei der es sich hier um eine Heißsiegelfolie aus einem Polymerkunststoff handelt, der für UV-Strahlung durchlässig ist. Es kann sich aber auch um eine plattenartige Abdeckung, z. B. aus Glas, handeln. Eine solche kann selbst auch wiederum ein Chip sein.

Besonders bevorzugt ist, daß der Kleber 6 seitlich in den Kanal 2 eingeführt wird. Dazu ist im dargestellten Ausführungsbeispiel vorgesehen, daß mindestens ein dort, wo die Hohlfaser 3 eingelegt ist, seitlich in den Kanal 2 mündender Zulaufkanal 7 vorgesehen ist, dessen anderes Ende eine Eintrittsstelle für einen im Verarbeitungszustand flüssigen Kleber 6 bildet. Der Zulaufkanal 7 befindet sich hier lateral seitlich des Kanals 2. Im Grundsatz könnte er auch orthogonal von unten her durch den Mikrostrukturträger 1, also beispielsweise einen Siliziumchip, in den Kanal 2 münden. Es geht dabei um die Zufuhr des Klebers 6 in den Zulaufkanal 7, die auf irgendeine Weise bewerkstelligt werden muß, beispielsweise durch eine Öffnung in der Abdeckfolie 5. Zu erwähnen ist hier, daß mehrere Anschlüsse auch in mehreren Ebenen liegen können im Sinne eines dreidimensionalen mikrofluidischen Netzwerkes wie oben bereits erwähnt.

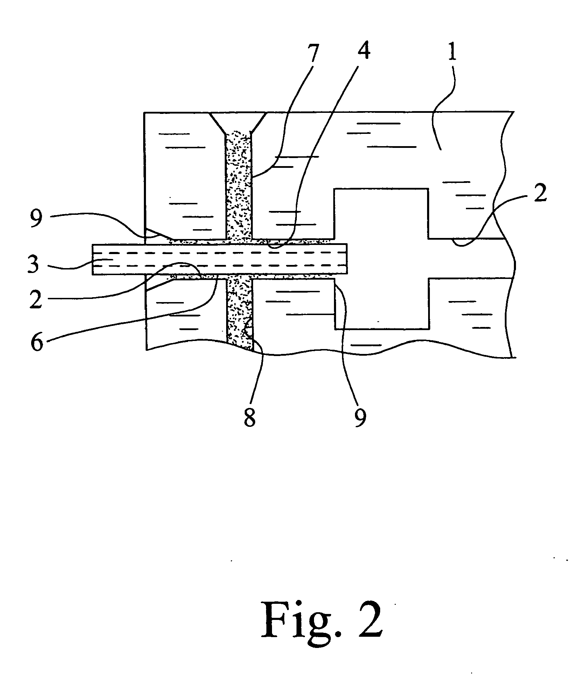

Fig. 1 und 2 zeigen weiter, daß mindestens ein dort, wo die Hohlfaser 3 eingelegt ist, seitlich vom Kanal 2 abgehender Ablaufkanal 8 vorgesehen ist, durch den überschüssiger Kleber 6 ablaufen kann. Man kann also unter Eigendruck des Klebers 6 diesen mit Überschuß dosieren und es ist sichergestellt, daß der Ablaufkanal 8 überschüssigen Kleber 6 abführt, so daß der Kleber 6 den Innenkanal in der Hohlfaser 3 nicht erreicht und blockiert.

Damit sich für die Hohlfaser 3 keine Blockierung deren Innenkanals ergibt, ist im dargestellten Ausführungsbeispiel vorgesehen, daß etwa dort, wo die Hohlfaser 3 aus dem Kanal 2 nach außen austritt, und etwa dort, wo sich im Kanal 2 das Ende der Hohlfaser 3 befindet, im Kanal 2 jedenfalls die Wandabschnitte mit einer den Kanal 2 verbreiternden, stufenartigen oder schräg verlaufenden Kapillarstopstruktur 9 ausgeführt sind. Man erkennt dazu in Fig. 2 in der Draufsicht, daß die Kapillarstopstruktur 9 am äußeren Ende des Kanals 2 eine trapezartige Erweiterung bildet. Ferner erkennt man in Fig. 2, daß im hier dargestellten Ausführungsbeispiel die Kapillarstopstruktur 9 am inneren Ende eine beidseitige Stufe bildet.

In beiden zuvor erläuterten Fällen, also an beiden Enden des Kanals 2, kann man davon ausgehen, daß die Modifikation durch die Kapillarstopstrukturen 9 auch an der Unterseite, also im Mikrostrukturträger 1, vorgesehen ist. Nicht vorgesehen dürfte diese Struktur sein an der Oberseite, weil dort mittels der Abdeckfolie 5, die solche Strukturen nicht erlaubt, der Mikrostrukturträger 1 des mikrofluidischen Netzwerkes glatt abgedeckt ist.

Die wannenartigen Kapillarstopstrukturen 9 in der Zeichnung können kleiner ausgeführt werden, also einen geringeren Inhalt haben, wenn man den Winkel am Ende der Hohlfaser 3 über 90° hinaus wählt, also rücklaufend "ohrenartige" Kapillarstoptrukturen 9 verwirklicht. Dann ist noch sicherer gewährleistet, daß sich keine Blockierung des Innenkanals der Hohlfaser 3 durch Kleber ergibt.

Im Extremfall kann man auch kurz vor dem Ende der Hohlfaser 3 an den seitlichen Kapillarkanälen 4 eigene kanalartige Kapillarstrukturen vorsehen, die gewissermaßen als "Saugkanäle" vor dem Ende der Hohlfaser 3 wirken und überschüssigen Kleber 6 in entsprechende Sammelräume abführen.

Eine alternative Kapillarstopstruktur 9 bildet eine Erweiterung oder Durchlaßstelle in einer als Maske ausgeführten Folie oder Platte auf dem mikrofluidischen Netzwerk an der Stelle, an der der Kleber 6 in den Kapillarkanälen 4 um die Hohlfaser 3 stehen bleiben soll.

Zusätzlich kann die bereits im allgemeinen Teil der Beschreibung erläuterte Beobachtung des Einleitens des Klebers 6 erfolgen, um den Kleber 6 dann bedarfsgerecht anzuhalten und/oder in den Endzustand zu überführen.

Um ein Gefühl für die Abmessungen zu haben, um die es hier geht, gibt die Lehre den Hinweis, daß der Kanal 2 mit einer Breite und Tiefe von etwa 30 µm bis etwa 500 µm, vorzugsweise von etwa 100 µm bis etwa 300 µm, ausgeführt wird und daß die Hohlfaser 3 mit darauf abgestimmten Abmessungen, insbesondere einem darauf abgestimmten Durchmesser von etwa 30µm bis etwa 500 µm, vorzugsweise von etwa 100 µm bis etwa 300 µm, ausgeführt ist. Der Innendurchmesser des Innenkanals in der Hohlfaser 3 dürfte dabei zwischen 5 µm und 450 µm, vorzugsweise zwischen etwa 50 µm und etwa 250 µm, betragen.

Als Fluid, das im Inneren der Hohlfaser 3 transportiert wird, kommt in erster Linie eine Flüssigkeit, beispielsweise eine bei der Dialyse relevante Flüssigkeit, in Frage. Grundsätzlich kommt aber auch ein Gas in Frage. Eine Dialysefaser als Hohlfaser 3 hat im übrigen einen halbdurchlässigen Mantel, der den Medienaustausch im Dialysegerät oder in einer meßtechnischen Struktur erlaubt.

Bevorzugte Varianten des Materials für die Hohlfaser sind Polymermaterial, ein Metall, beispielsweise Edelstahl, Glas oder auch Keramik oder Cellulose,

Bereits oben ist darauf hingewiesen worden, daß man als Kleber 6 insbesondere einen unter UV-Strahlung aushärtenden Kleber verwenden kann, der genau gesteuert seinen Aushärtungsprozeß beginnt und beendet. Wenn man einen solchen Kleber 6 verwendet, so sollte man die Abdeckfolie 5 oder Abdeckplatte aus einem für UV-Strahlung durchlässigen Material ausführen. Für den Kleber 6 kommen z. B. Acrylate, Urethane, aber auch Zweikomponenten-Epoxydharze in Frage. Die Abdeckfolie 5 kann z. B. aus Polycarbonat, Polyester, Polystyrol oder PVC bestehen bzw. auf dieser Grundlage hergestellt sein.

Bereits oben ist im übrigen erläutert worden, daß der Kleber 6 im Verarbeitungszustand eine Viskosität von etwa 100 mPas bis etwa 400 mPas aufweisen sollte.

Nicht dargestellt in der Zeichnung ist eine Variante, für die gilt, daß der Kanal 2 mit einer Breite ausgeführt wird, die etwa dem Doppelten der Tiefe entspricht und es ermöglicht, zwei Hohlfasern 3 gleichzeitig in einem Kanal 2 zu verkleben. Entsprechendes kann auch für eine dreikanalige Ausführung o.dgl. gelten.

Fig. 1 zeigt insoweit eine bevorzugte Ausführungsform der Erfindung als mehrere Kanäle 2 des Netzwerkes, in die Hohlfasern 3 eingelegt werden, durch mindestens einen Verbindungskanal 10 für den Kleber 6 miteinander verbunden sind, der die Funktion des Ablaufkanals für einen Kanal 2 und die Funktion des Zulaufkanals für den anderen Kanal 2 verfüllt. Man kann sich anhand von Fig. 2 gut vorstellen, wie dieses mikrofluidische System zum Einleiten des Klebers 6 in das Netzwerk bei im wesentlichen vertikaler Ausrichtung von oben ausgehend, nämlich vom Eintritt des Zulaufkanals 7 her befüllt wird. Damit ergibt sich von selbst der Austritt des flüssigen Klebers 6 aus dem Ablaufkanal 8 am unteren Ende des mikrofluidischen Netzwerks. Durch Kapillarkräfte erfolgt die Seitenverteilung in die Kanäle 2 mit den Hohlfasern 3 so weit, bis die Kapillarstopstrukturen 9 stoppen.

Zum Aushärten wird die gesamte Anordnung in die horizontale Ausrichtung gebracht und dann mit UV-Strahlung bestrahlt.

## Patentansprüche

1. Verfahren zum Koppeln mindestens einer mikrofluidischen Hohlfaser an ein mikrofluidisches Netzwerk,
wobei das mikrofluidische Netzwerk mindestens einen oberseitig offenen Kanal (2) aufweist, in dem die Hohlfaser (3) mit einem Ende eingelegt wird, und:
a) die Außenabmessungen der Hohlfaser (3) so auf die Innenabmessungen des Kanals (2) abgestimmt werden, daß sich zwischen der Hohlfaser (3) und den Kanalwandungen in in den Winkeln verbleibenden Zwickeln Kapillarkanäle (4) ergeben;
b) das mikrofluidische Netzwerk bei im Kanal (2) einliegender Hohlfaser (3) mit einer Abdeckfolie oder -platte (5) abgedeckt wird, die auf dem Netzwerk fixiert wird und den Kanal (2) oberseitig schließt;
c) durch mindestens einen in den Kanal (2) mündenden Zulaufkanal (7) im mikrofluidischen Netzwerk wird ein im Endzustand fluidisch dichtender, im Verarbeitungszustand flüssiger Kleber (6) in den Kanal (2) dort eingeleitet, wo die Hohlfaser (3) einliegt, so daß sich die Kapillarkanäle (4) um die Hohlfaser (3) herum füllen;
d) nach Abschluß des Verfahrensschrittes c) wird der Kleber (6) in den Endzustand gebracht, insbesondere ausgehärtet, bzw. erreicht diesen;
**dadurch gekennzeichnet,**
**daß** das Eindringen des noch flüssigen Klebers (6) endseitig in die Hohlfaser (3) durch eine den Kanal (2) verbreiternde, sich an der offenen Mündung der Hohlfaser (3) befindende Kapillarstopstruktur (9), damit der Kleber (6) vor oder am Ende der Hohlfaser (3) stehen bleibt, verhindert wird.

2. Verfahren nach Anspruch 1, **dadurch gekennzeichnet, daß** durch mindestens einen vom Kanal (2) abgehenden Ablaufkanal (8) im mikrofluidischen Netzwerk überschüssiger Kleber (6) im Verarbeitungszustand aus dem Kanal (2) abgeleitet wird und/oder daß im Verfahrensschritt b) die Abdeckfolie oder -platte (5) die Hohlfaser (3) im Kanal (2) vorläufig fixiert.

3. Verfahren nach Anspruch 1 oder 2, **dadurch gekennzeichnet, daß** die Kapillarstopstruktur (9) durch den Kanal (2) vorzugsweise stufenartig verbreiternde Wandabschnitte und/oder einen insbesondere stirnseitigen Absatz der Hohlfaserwandung gebildet wird.

4. Verfahren nach einem der vorhergehenden Ansprüche, **dadurch gekennzeichnet, daß** die Abdeckfolie oder -platte (5) oder eine zusätzliche Folie oder Platte auf dem mikrofluidischen Netzwerk als Maske mit einer Durchlaßstelle an der Stelle, an der der Kleber (6) in den Kapillarkanälen (4) um die Hohlfaser (3) stehen bleiben soll, ausgeführt ist und daß während des Einleitens des Klebers (6) an der Durchlaßstelle eine solche Beeinflussung des Klebers (6) erfolgt, daß dieser hier seinen Endzustand erreicht.

5. Verfahren nach einem der vorhergehenden Ansprüche, **dadurch gekennzeichnet, daß** etwa dort, wo die Hohlfaser (3) aus dem Kanal (2) nach außen austritt, im Kanal (2) jedenfalls die Wandabschnitte mit einer den Kanal (2) verbreiternden, vorzugsweise stufenartigen oder schräg verlaufenden Kapillarstopstroktur (9) versehen sind.

6. Verfahren nach einem der vorhergehenden Ansprüche, **dadurch gekennzeichnet, daß** während des Einleitens des Klebers (6) in die Kapillarkanäle (4) um die Hohlfaser (3) das Fließen des Klebers (6) erfaßt, insbesondere beobachtet wird und dann, wenn der Kleber (6) eine Stelle erreicht, an der er stehen bleiben soll, der Kleber (6) in den Endzustand gebracht wird.

7. Verfahren nach einem der vorhergehenden Ansprüche, **dadurch gekennzeichnet, daß** der Kanal (2) mit einer Breite und Tiefe von etwa 30 µm bis etwa 500 µm, vorzugsweise etwa 100 µm bis etwa 300 µm, ausgeführt wird und daß die Hohlfaser (3) mit darauf abgestimmten Abmessungen, insbesondere einem darauf abgestimmten Durchmesser, von etwa 30 µm bis etwa 500 µm, vorzugsweise etwa 100 µm bis etwa 300 µm, ausgeführt wird.

8. Verfahren nach einem der vorhergehenden Ansprüche, **dadurch gekennzeichnet, daß** als Hohlfaser (3) eine Faser aus Polymermaterial, aus Metall, aus Glas, aus Keramik oder aus Cellulose verwendet wird und/oder daß als Hohlfaser (3) eine Dialysefaser verwendet wird.

9. Verfahren nach einem der vorhergehenden Ansprüche, **dadurch gekennzeichnet, daß** als Kleber (6) ein flüssiger Klebstoff mit einer Viskosität von etwa 10 mPas bis etwa 600 mPas, vorzugsweise von etwa 100 mPas bis etwa 400 mPas, verwendet wird.

10. Verfahren nach einem der vorhergehenden Ansprüche, **dadurch gekennzeichnet, daß** als Kleber (6) ein unter UV-Strahlung aushärtender Klebstoff verwendet und der Kleber (6) durch Bestrahlen mit UV-Strahlung in den Endzustand gebracht wird.

11. Verfahren nach einem der vorhergehenden Ansprüche, **dadurch gekennzeichnet, daß** für die Abdeckfolie oder -platte (5) ein für UV-Strahlung durchlässiges Material verwendet wird.

12. Verfahren nach einem der vorhergehenden Ansprüche, **dadurch gekennzeichnet, daß** der Kleber (6) quasi drucklos, also im wesentlichen nur unter Eigendruck des Klebervorrats, in den Kanal (2) eingeleitet wird.

13. Verfahren nach einem der vorhergehenden Ansprüche, **dadurch gekennzeichnet, daß** das Einleiten des Klebers (6) in das Netzwerk bei im wesentlichen vertikaler Ausrichtung des Netzwerkes von oben aus erfolgt.

14. Verfahren nach einem der vorhergehenden Ansprüche, **dadurch gekennzeichnet, daß** das Fixieren des Klebers (6), insbesondere das Aushärten des Klebers (6), bei im wesentlichen horizontaler Ausrichtung des Netzwerkes erfolgt.

15. Verfahren nach einem der vorhergehenden Ansprüche, **dadurch gekennzeichnet, daß** der Kanal (2) mit einer Breite ausgeführt wird, die etwa dem Doppelten der Tiefe entspricht und es ermöglicht, zwei Hohlfasern (3) gleichzeitig in einem Kanal (2) zu verkleben.

16. Verfahren nach einem der vorhergehenden Ansprüche, **dadurch gekennzeichnet, daß** mehrere Kanäle (2) des Netzwerkes, in die Hohlfasern (3) eingelegt werden, durch mindestens einen Verbindungskanal (10) für den Kleber (6) miteinander verbunden werden, der die Funktion des Ablaufkanals (8) für einen Kanal (2) und die Funktion des Zulaufkanals (7) für den anderen Kanal (2) erfüllt.

17. Mikrofluidisches System aus einem mikrofluidischen Netzwerk mit einem Mikrostrukturträger (1) mit mindestens einem Kanal (2) und einer mit einem Ende im Kanal (2) eingelegten, stirnseitig in den Kanal (2) mündenden mikrofluidischen Hohlfaser (3),
wobei die Außenabmessungen der Hohlfaser (3) so auf die Innenabmessungen des Kanals (2) abgestimmt sind, daß zwischen der Hohlfaser (3) und den Wandungen des Kanals (2) in in den Winkeln verbleibenden Zwickeln Kapillarkanäle (4) vorliegen, und
wobei die Kapillarkanäle (4) mit einem fluidisch dichtenden Kleber (6) ausgefüllt sind,
**dadurch gekennzeichnet,**
**daß** an der offenen Mündung der Hohlfaser (3) eine den Kanal (2) verbreiternde Kapillarstopstruktur (9) damit der Kleber (6) vor oder am Ende der Hohlfaser (3) stehen bleibt, vorgesehen ist, um ein Eindringen des Klebers (6) im flüssigen Zustand endseitig in die Hohlfaser (3) zu verhindern.

18. Mikrofluidisches System nach Anspruch 17, **dadurch gekennzeichnet, daß** das Netzwerk mit einer auf dem Mikrostrnkturträger (1) fixierten Abdeckfolie oder -platte (5) abgedeckt ist, die den Kanal (2) schließt, insbesondere wobei die Abdeckfolie oder -platte (5) die Hohlfaser (3) im Kanal (2) vorläufig bis zum Einfüllen und Aushärten des Klebers (6) fixiert.

19. Mikrofluidisches System nach Anspruch 17 oder 18, **dadurch gekennzeichnet, daß** die Kapillarstopstruktur (9) durch den Kanal (2) vorzugsweise stufenartig verbreiternde Wandabschnitte und/oder einen insbesondere stirnseitigen Absatz der Hohlfaserwandung gebildet ist.

20. Mikrofluidisches System nach einem der Ansprüche 17 bis 19, **dadurch gekennzeichnet, daß** die Kapillarstopstruktur (9) am inneren Ende eine beidseitige Stufe bildet.

21. Mikrofluidisches System nach einem der Ansprüche 17 bis 20, **dadurch gekennzeichnet, daß** etwa dort, wo die Hohlfaser (3) aus dem Kanal (2) nach außen austritt, im Kanal (2) jedenfalls die Wandabschnitte mit einer den Kanal (2) verbreiternden, vorzugsweise stufenartigen oder schräg verlaufenden, äußeren Kapillarstopstruktur (9) ausgeführt sind.

22. Milcrofluidisches System nach Anspruch 21, **dadurch gekennzeichnet, daß** die äußere Kapillarstopstruktur (9) am äußeren Ende des Kanals (2) eine trapezartige Erweiterung bildet.

23. Mikrofluidisches System nach einem der Ansprüche 17 bis 22, **dadurch gekennzeichnet, daß** die Abdeckfolie oder -platte (5) oder eine zusätzliche Folie oder Platte auf dem mikrofluidischen Netzwerk als Maske mit einer Durchlaßstelle oder Erweiterung an der Stelle, an der der Kleber (6) in den Kapillarkanälen (4) um die Hohlfaser (3) stehen bleiben soll, ausgeführt ist.

24. Mikrofluidisches System nach einem der Ansprüche 17 bis 23, **dadurch gekennzeichnet daß** mindestens ein dort, wo die Hohlfaser (3) eingelegt ist, seitlich in den Kanal (2) mündender Zulaufkanal (7) vorgesehen ist, dessen anderes Ende eine Eintrittsstelle für den im Verarbeitungszustand flüssigen Kleber (6) bildet.

25. Mikrofluidisches System nach einem der Ansprüche 17 bis 24, **dadurch gekennzeichnet, daß** mindestens ein dort, wo die Hohlfaser (3) eingelegt ist, seitlich vom Kanal (2) abgehender Ablaufkanal (8) vorgesehen ist, durch den überschüssiger Kleber (6) ablaufen kann.

26. Mikrofluidisches System nach einem der Ansprüche 17 bis 25, **dadurch gekennzeichnet, daß** der Kanal (2) mit einer Breite und Tiefe von etwa 30 µm bis etwa 500 µm, vorzugsweise etwa 100 µm bis etwa 300 µm, ausgeführt ist und daß die Hohlfaser (3) mit darauf abgestimmten Abmessungen, insbesondere einem darauf abgestimmten Durchmesser, von etwa 30 µm bis etwa 500 µm, vorzugsweise etwa 100 µm bis etwa 300 µm, ausgeführt ist.

27. Mikrofluidisches System nach einem der vorgehenden Vorrichtungsansprüche, **dadurch gekennzeichnet, daß** die Hohlfaser (3) eine Faser aus Polymermaterial, Metall, Glas, Keramik oder Cellulose ist und/oder daß die Hohlfaser (3) eine Dialysefaser ist.

28. Mikrofluidisches System nach einem der Ansprüche 17 bis 27, **dadurch gekennzeichnet, daß** der Kleber (6) ein Klebstoff ist, der im flüssigen Verarbeitungszustand eine Viskosität von etwa 10 mPas bis etwa 600 mPas, vorzugsweise von etwa 100 mPas bis etwa 400 mPas, aufweist.

29. Mikrofluidisches System nach einem der Ansprüche 17 bis 28, **dadurch gekennzeichnet, daß** der Kleber (6) ein unter UV-Strahlung ausgehärteter Kleber ist.

30. Mikrofluidisches System nach einem der Ansprüche 17 bis 29, **dadurch gekennzeichnet, daß** die Abdeckfolie oder -platte (5) aus einem für Ultraviolett-Strahlung durchlässigen Material besteht, insbesondere wobei die Abdeckfolie (5) eine Heißsiegelfolie ist.

31. Mikrofluidisches System nach einem der Ansprüche 17 bis 30, **dadurch gekennzeichnet, daß** der Kanal (2) mit einer Breite ausgeführt ist, die etwa dem Doppelten der Tiefe des Kanals (2) entspricht, und daß zwei Hohlfasern (3) gleichzeitig in einem Kanal (2) verklebt sind.

32. Mikrofluidisches System nach einem der Ansprüche 17 bis 31, **dadurch gekennzeichnet, daß** mehrere Kanäle (2) des Netzwerks, in die Hohlfasern (3) eingelegt sind, durch mindestens einen Verbindungskanal (10) für den Kleber (6) miteinander verbunden sind, der die Funktion des Ablaufkanals für einen Kanal (2) und die Funktion des Zulaufkanals für den anderen Kanal (2) erfüllt.

33. Mikrofluidisches System nach einem der Ansprüche 17 bis 32, **dadurch gekennzeichnet, daß** der Zulaufkanal (7) und/oder der Ablaufkanal (8) in einem rechten Winkel auf den Kanal (2) stößt bzw. stoßen.

## Claims

1. Process for coupling at least one microfluidic hollow fibre to a microfluidic network,
wherein the microfluidic network comprises at least one channel (2) open on a top side, in which one end of the hollow fibre (3) is placed, and:
a) the outside dimensions of the hollow fibre (3) are matched to the inside dimensions of the channel (2) such that capillary channels (4) are formed between the hollow fibre (3) and the channel walls in gaps remaining in the corners;
b) when the hollow fibre (3) has been placed in the channel (2) the microfluidic network is covered by a cover film or plate (5) which is fixed on the network and closes off the channel (2) at the top side;
c) a cement (6) that is liquid in a processing state and forms a fluidic seal in its final state is introduced into the channel (2) where the hollow fibre (3) is located through at least one feed channel (7) that opens into the channel (2) in the microfluidic network, so that the capillary channels (4) around the hollow fibre (3) are filled;
d) after step c) has ended, the cement (6) is brought into its final state, more particularly cured, or reaches this state;
**characterised in that**
the still liquid cement (6) is prevented from penetrating into the hollow fibre (3) at its end region by a capillary stop structure (9) that widens the channel (2) and is located at the open mouth of the hollow fibre (3), so that the cement (6) stops before or at the end of the hollow fibre (3).

2. Process according to claim 1, **characterised in that** excess cement (6) in the processing state is removed from the channel (2) by at least one drain channel (8) extending from the channel (2) in the microfluidic network, and/or in step b) the cover film or plate (5) temporarily fixes the hollow fibre (3) in the channel (2).

3. Process according to claim 1 or 2, **characterised in that** the capillary stop structure (9) is formed by wall sections which widen the channel (2), preferably by steps, and/or a step arranged in particular at the end face of the hollow fibre wall,

4. Process according to one of the preceding claims, **characterised in that** the cover film or plate (5) or an additional film or plate on the microfluidic network is configured as a mask with a passage point at the location where the cement (6) is intended to remain in the capillary channels (4) about the hollow fibre (3), and that during the introduction of the cement (6) at the passage point the cement (6) is acted upon to bring it into its final state at this point.

5. Process according to one of the preceding claims, **characterised in that** roughly at the point where the hollow fibre (3) emerges from the channel (2), the wall sections in the channel (2) are provided with a capillary stop structure (9) that widens the channel (2), preferably by steps, or runs diagonally.

6. Process according to one of the preceding claims, **characterised in that** during the introduction of the cement (6) into the capillary channels (4) around the hollow fibre (3), the flow of the cement (6) is detected, particularly observed, and when the cement (6) reaches a point where it is intended to remain, the cement (6) is brought into the final state.

7. Process according to one of the preceding claims, **characterised in that** the channel (2) is made with a width and depth of about 30 µm to about 500 µm, preferably about 100 µm to about 300 µm, and **in that** the hollow fibre (3) is made with dimensions matched thereto, particularly a diameter matched thereto, of about 30 µm to about 500 µm, preferably about 100 µm to about 300 µm.

8. Process according to one of the preceding claims, **characterised in that** a fibre made of polymer material, metal, glass, ceramics or cellulose is used as the hollow fibre (3) and/or that a dialysis fibre is used as the hollow fibre (3).

9. Process according to one of the preceding claims, **characterised in that** the cement (6) is a liquid adhesive with a viscosity of about 10 mPas to about 600 mPas, preferably from about 100 mPas to about 400 mPas.

10. Process according to one of the preceding claims, **characterised in that** the cement (6) is an adhesive that cures under UV radiation and the cement (6) is brought into the final state by irradiating with UV radiation.

11. Process according to one of the preceding claims, **characterised in that** a material permeable to UV radiation is used for the cover film or plate (5).

12. Process according to one of the preceding claims, **characterised in that** the adhesive (6) is introduced into the channel (2) in a virtually pressureless manner, i.e. essentially under only the natural pressure of the cement supply.

13. Process according to one of the preceding claims, **characterised in that** the introduction of the cement (6) into the network takes place from above with the network aligned substantially vertically.

14. Process according to one of the preceding claims, **characterised in that** the fixing of the cement (6), particularly the curing of the cement (6), takes place with the network aligned substantially horizontally.

15. Process according to one of the preceding claims, **characterised in that** the channel (2) is made with a width that corresponds substantially to twice its depth and enables it to cement two hollow fibres (3) simultaneously in a channel (2).

16. Process according to one of the preceding claims, **characterised in that** a plurality of channels (2) of the network are placed in the hollow fibres (3), and are joined together by at least one connecting channel (10) for the cement (6) which acts as the drain channel (8) for one channel (2) and as the feed channel (7) for the other channel (2).

17. Microfluidic system comprising a microfluidic network with a microstructure carrier (1) having at least one channel (2) and a microfluidic hollow fibre (3) one end of which is placed in the channel (2) and which discharges into the channel (2) at its end region,
wherein the outside dimensions of the hollow fibre (3) are matched to the inside dimensions of the channel (2) such that capillary channels (4) are formed between the hollow fibre (3) and the walls of the channel (2) in gaps remaining in the corners, and
wherein the capillary channels (4) are filled with a fluidically sealing cement (6), **characterised in that**
on the open mouth of the hollow fibre (3) is provided a capillary stop structure (9) that widens the channel (2), so that the cement (6) comes to a standstill before or at the end of the hollow fibre (3), to prevent the cement (6) in the liquid state from penetrating into the hollow fibre (3) at the end region thereof.

18. Microfluidic system according to claim 17, **characterised in that** the network is covered with a cover film or plate (5) fixed to the microstructure carrier (1) which closes off the channel (2), while in particular the cover film or plate (5) temporarily secures the hollow fibre (3) in the channel (2) until the cement (6) has been introduced and cured.

19. Microfluidic system according to claim 17 or 18, **characterised in that** the capillary stop structure (9) is formed by wall sections that widen the channel (2), preferably by steps, and/or a step in the hollow fibre wall, particularly at the end region thereof.

20. Microfluidic system according to one of claims 17 to 19, **characterised in that** the capillary stop structure (9) forms a bilateral step at the inner end.

21. Microfluidic system according to one of claims 17 to 20, **characterised in that** roughly at the point where the hollow fibre (3) emerges from the channel (2) to the outside, in the channel (2) in each case the wall portions are embodied with an outer capillary stop structure (9) that widens the channel (2) and preferably extends in steps or diagonally.

22. Microfluidic system according to claim 21, **characterised in that** the outer capillary stop structure (9) forms a trapezoidal widening at the outer end of the channel (2).

23. Microfluidic system according to one of claims 17 to 22, **characterised in that** the cover film or plate (5) or an additional film or plate on the microfluidic network is configured as a mask with a passage point or widening at the location where the cement (6) is intended to remain in the capillary channels (4) around the hollow fibre (3).

24. Microfluidic system according to one of claims 17 to 23, **characterised in that** at least one feed channel (7) is provided that discharges laterally into the channel (2) at the point where the hollow fibre (3) is placed therein, its other end forming an entry point for the cement (6) that is liquid in the processing state.

25. Microfluidic system according to one of claims 17 to 24, **characterised in that** at least one drain channel (8) through which excess cement (6) can drain away is provided that drains laterally from the channel (2) at the point where the hollow fibre (3) is placed therein.

26. Microfluidic system according to one of claims 17 to 25, **characterised in that** the channel (2) is made with a width and depth of about 30 µm to about 500 µm, preferably about 100 µm to about 300 µm, and **in that** the hollow fibre (3) is made with dimensions matched thereto, particularly a diameter matched thereto, of about 30 µm to about 500 µm, preferably about 100 µm to about 300 µm.

27. Microfluidic system according to one of the preceding apparatus claims, **characterised in that** the hollow fibre (3) is a fibre made of polymer material, metal, glass, ceramics or cellulose and/or that the hollow fibre (3) is a dialysis fibre.

28. Microfluidic system according to one of claims 17 to 27, **characterised in that** the cement (6) is an adhesive which, in the liquid processing state, has a viscosity of about 10 mPas to about 600 mPas, preferably from about 100 mPas to about 400 mPas.

29. Microfluidic system according to one of claims 17 to 28, **characterised in that** the cement (6) is an adhesive that cures under UV radiation.

30. Microfluidic system according to one of claims 17 to 29, **characterised in that** the cover film or plate (5) consists of a material permeable to UV radiation, the cover film (5) in particular being a heat sealable film.

31. Microfluidic system according to one of claims 17 to 30, **characterised in that** the channel (2) is made with a width that corresponds to approximately twice the depth of the channel (2), and **in that** two hollow fibres (3) are simultaneously cemented in a channel (2).

32. Microfluidic system according to one of claims 17 to 31, **characterised in that** a plurality of channels (2) of the network in which hollow fibres (3) are placed are connected to one another by at least one connecting channel (10) for the cement (6) which acts as the drain channel for a channel (2) and as the feed channel for the other channel (2).

33. Microfluidic system according to one of claims 17 to 32, **characterised in that** the feed channel (7) and/or the drain channel (8) meet the channel (2) at a right angle.

## Revendications

1. Procédé pour coupler au moins une fibre creuse microfluidique à un réseau microfluidique,
sachant que le réseau microfluidique présente au moins un canal (2) ouvert côté supérieur, dans lequel la fibre creuse (3) est insérée par une extrémité, et :
a) les dimensions extérieures de la fibre creuse (3) sont adaptées aux dimensions intérieures du canal (2) de sorte qu'il résulte des canaux capillaires (4) entre la fibre creuse (3) et les parois de canal dans des coins restant dans les angles ;
b) le réseau microfluidique est recouvert, lorsque la fibre creuse (3) est dans le canal (2), par un film ou une plaque de recouvrement (5) qui est fixée sur le réseau et ferme côté supérieur le canal (2) ;
c) une colle (6) liquide à l'état de transformation, étanche au fluide à l'état final est introduite dans le canal (2) par au moins un canal d'amenée (7) débouchant dans le canal (2) dans le réseau microfluidique là où la fibre creuse (3) se situe de sorte que les canaux capillaires (4) se remplissent autour de la fibre creuse (3) ;
d) la colle (6) est amenée à l'état final, en particulier est durcie ou l'atteint à la fin de l'étape de procédé c) ;
**caractérisé en ce que** l'introduction de la colle encore liquide (6) est empêchée côté extrémité dans la fibre creuse (3) par une structure d'arrêt capillaire (9) se trouvant sur l'ouverture ouverte de la fibre creuse (3), élargissant le canal (2), afin que la colle (6) s'arrête devant ou à l'extrémité de la fibre creuse (3).

2. Procédé selon la revendication 1, **caractérisé en ce que** de la colle (6) excédentaire à l'état de transformation est dérivée du canal (2) par au moins un canal d'évacuation (8) sortant du canal (2) dans le réseau microfluidique et/ou **en ce qu'**à l'étape de procédé b), le film ou la plaque de recouvrement (5) fixe temporairement la fibre creuse (3) dans le canal (2).

3. Procédé selon la revendication 1 ou 2, **caractérisé en ce que** la structure d'arrêt capillaire (9) est formée par des sections de paroi élargissant le canal (2) de préférence en gradin et/ou un talon notamment côté frontal de la paroi de fibre creuse.

4. Procédé selon l'une quelconque des revendications précédentes, **caractérisé en ce que** le film ou la plaque de recouvrement (5) ou un film ou une plaque supplémentaire sur le réseau microfluidique est réalisée comme un masque avec un point de passage à l'endroit où la colle (6) doit s'arrêter dans les canaux capillaires (4) autour de la fibre creuse (3) et **en ce que** pendant l'introduction de la colle (6) sur le point de passage, la colle (6) est influencée de façon à atteindre ici son état final.

5. Procédé selon l'une quelconque des revendications précédentes, **caractérisé en ce que** par exemple là où la fibre creuse (3) sort du canal (2) vers l'extérieur, les sections de paroi sont pourvues en tout cas dans le canal (2) d'une structure d'arrêt capillaire (9) élargissant le canal (2), s'étendant de préférence en gradin ou en biais.

6. Procédé selon l'une quelconque des revendications précédentes, **caractérisé en ce que** pendant l'introduction de la colle (6) dans les canaux capillaires (4) autour de la fibre creuse (3), l'écoulement de la colle (6) est détecté, en particulier observé et si la colle (6) atteint un endroit, sur lequel elle doit s'arrêter, celle-ci est amenée à l'état final.

7. Procédé selon l'une quelconque des revendications précédentes, **caractérisé en ce que** le canal (2) est réalisé avec une largeur et une profondeur d'environ 30 µm à environ 500 µm, de préférence d'environ 100 µm à environ 300 µm et **en ce que** la fibre creuse (3) est réalisée avec des dimensions adaptées à celui-ci, en particulier un diamètre adapté à celui-ci d'environ 30 µm à environ 500 µm, de préférence d'environ 100 µm à environ 300 µm.

8. Procédé selon l'une quelconque des revendications précédentes, **caractérisé en ce qu'**une fibre en matériau polymère, en métal, en verre, en céramique ou en cellulose est utilisée comme fibre creuse (3) et/ou **en ce qu'**une fibre de dialyse est utilisée comme fibre creuse (3).

9. Procédé selon l'une quelconque des revendications précédentes, **caractérisé en ce qu'**une colle liquide présentant une viscosité d'environ 10 mPas à environ 600 mPas, de préférence d'environ 100 mPas à environ 400 mPas est utilisée comme colle (6).

10. Procédé selon l'une quelconque des revendications précédentes, **caractérisé en ce qu'**une colle durcissant sous rayonnement ultraviolet est utilisée comme colle (6) et la colle (6) est amenée à l'état final par rayonnement ultraviolet.

11. Procédé selon l'une quelconque des revendications précédentes, **caractérisé en ce qu'**un matériau perméable au rayonnement ultraviolet est utilisé pour le film ou la plaque de recouvrement (5).

12. Procédé selon l'une quelconque des revendications précédentes, **caractérisé en ce que** la colle (6) est introduite dans le canal (2) quasiment sans pression, donc sensiblement uniquement sous la propre pression du réservoir de colle.

13. Procédé selon l'une quelconque des revendications précédentes, **caractérisé en ce que** la colle (6) est introduite dans le réseau par le haut lorsque l'orientation du réseau est sensiblement verticale.

14. Procédé selon l'une quelconque des revendications précédentes, **caractérisé en ce que** la fixation de la colle (6), en particulier le durcissement de la colle (6), est effectué lorsque l'orientation du réseau est sensiblement horizontale.

15. Procédé selon l'une quelconque des revendications précédentes, **caractérisé en ce que** le canal (2) est réalisé avec une largeur qui correspond à peu près au double de la profondeur et permet de coller simultanément deux fibres creuses (3) dans un canal (2).

16. Procédé selon l'une quelconque des revendications précédentes, **caractérisé en ce que** plusieurs canaux (2) du réseau, dans lesquels des fibres creuses (3) sont introduites, sont reliés entre eux par au moins un canal de liaison (10) pour la colle (6), qui remplit la fonction du canal d'évacuation (8) pour un canal (2) et la fonction du canal d'amenée (7) pour l'autre canal (2).

17. Système microfluidique composé d'un réseau microfluidique présentant un support microstructurel (1) avec au moins un canal (2) et une fibre creuse (3) microfluidique débouchant côté frontal dans le canal (2), insérée par une extrémité dans le canal (2),
sachant que les dimensions extérieures de la fibre creuse (3) sont adaptées aux dimensions intérieures du canal (2) de sorte qu'il résulte des canaux capillaires (4) entre la fibre creuse (3) et les parois de canal (2) dans des coins restant dans les angles,
et sachant que les canaux capillaires (4) sont remplis d'une colle (6) étanche au fluide,
**caractérisé en ce qu'**une structure d'arrêt capillaire (9) élargissant le canal (2) afin que la colle (6) s'arrête devant ou à l'extrémité de la fibre creuse (3), est prévue sur l'ouverture ouverte de la fibre creuse (3) afin d'empêcher une pénétration de la colle (6) à l'état liquide côté extrémité dans la fibre creuse (3).

18. Système microfluidique selon la revendication 17, **caractérisé en ce que** le réseau est recouvert par un film ou une plaque de recouvrement (5) fixée sur le support microstructurel (1), fermant le canal (2), en particulier sachant que le film ou la plaque de recouvrement (5) fixe temporairement la fibre creuse (3) dans le canal (2) jusqu'au remplissage et durcissement de la colle (6).

19. Système microfluidique selon la revendication 17 ou 18, **caractérisé en ce que** la structure d'arrêt capillaire (9) est constituée de sections de paroi élargissant de préférence en gradin le canal (2) et/ou d'un talon notamment côté frontal de la paroi de fibre creuse.

20. Système microfluidique selon l'une quelconque des revendications 17 à 19, **caractérisé en ce que** la structure d'arrêt capillaire (9) forme un gradin bilatéral sur l'extrémité intérieure.

21. Système microfluidique selon l'une quelconque des revendications 17 à 20, **caractérisé en ce que** par exemple là où la fibre creuse (3) sort du canal (2) vers l'extérieur, les sections de paroi sont réalisées en tout cas dans le canal (2) avec une structure d'arrêt capillaire (9) élargissant le canal (2), s'étendant de préférence en gradin ou en biais.

22. Système microfluidique selon la revendication 21, **caractérisé en ce que** la structure d'arrêt capillaire extérieure (9) forme un élargissement trapézoïdal sur l'extrémité extérieure du canal (2).

23. Système microfluidique selon l'une quelconque des revendications 17 à 22, **caractérisé en ce que** le film ou la plaque de recouvrement (5) ou un film ou une plaque supplémentaire sur le réseau microfluidique est réalisée comme un masque avec un point de passage ou élargissement à l'endroit où la colle (6) doit s'arrêter dans les canaux capillaires (4) autour de la fibre creuse (3).

24. Système microfluidique selon l'une quelconque des revendications 17 à 23, **caractérisé en ce qu'**au moins un canal d'amenée (7) débouchant latéralement dans le canal (2) là où la fibre creuse (3) est introduite, est prévu, dont l'autre extrémité forme un point d'entrée pour la colle (6) liquide à l'état de transformation.

25. Système microfluidique selon l'une quelconque des revendications 17 à 24, **caractérisé en ce qu'**au moins un canal d'évacuation (8) sortant latéralement du canal (2) là où la fibre creuse (3) est introduite, est prévu, par lequel de la colle (6) excédentaire peut s'écouler.

26. Système microfluidique selon l'une quelconque des revendications 17 à 25, **caractérisé en ce que** le canal (2) est réalisé avec une largeur et une profondeur d'environ 30 µm à environ 500 µm, de préférence d'environ 100 µm à environ 300 µm et **en ce que** la fibre creuse (3) est réalisée avec des dimensions adaptées à celui-ci, en particulier un diamètre adapté à celui-ci d'environ 30 µm à environ 500 µm, de préférence d'environ 100 µm à environ 300 µm.

27. Système microfluidique selon l'une quelconque des revendications précédentes, **caractérisé en ce que** la fibre creuse (3) est une fibre en matériau polymère, en métal, en verre, en céramique ou en cellulose et/ou en ce que la fibre creuse (3) est une fibre de dialyse.

28. Système microfluidique selon l'une quelconque des revendications 17 à 27, **caractérisé en ce que** la colle (6) est une colle qui présente à l'état de transformation liquide une viscosité d'environ 10 mPas à environ 600 mPas, de préférence d'environ 100 mPas à environ 400 mPas.

29. Système microfluidique selon l'une quelconque des revendications 17 à 28, **caractérisé en ce que** la colle (6) est une colle durcie sous rayonnement UV.

30. Système microfluidique selon l'une quelconque des revendications 17 à 29, **caractérisé en ce que** le film ou la plaque de recouvrement (5) se compose d'un matériau perméable au rayonnement ultraviolet, en particulier sachant que le film de recouvrement (5) est un film collé à chaud.

31. Système microfluidique selon l'une quelconque des revendications 17 à 30, **caractérisé en ce que** le canal (2) est réalisé avec une largeur qui correspond à peu près au double de la profondeur du canal (2) et **en ce que** deux fibres creuses (3) sont simultanément collées dans un canal (2).

32. Système microfluidique selon l'une quelconque des revendications 17 à 31, **caractérisé en ce que** plusieurs canaux (2) du réseau, dans lesquels sont introduites des fibres creuses (3), sont reliés entre eux par au moins un canal de liaison (10) pour la colle (6), qui remplit la fonction du canal d'évacuation pour un canal (2) et la fonction du canal d'amenée pour l'autre canal (2).

33. Système microfluidique selon l'une quelconque des revendications 17 à 32, **caractérisé en ce que** le canal d'amenée (7) et/ou le canal d'évacuation (8) bute ou butent dans un angle droit sur le canal (2).
